# EUROPEAN PATENT APPLICATION

(11) **EP 3 396 598 A2**
(43) Date of publication of application: **31.10.2018**
(21) Application number: 18382345.9
(22) Date of filing: 21.05.2018
(51) Int. Cl.: G06N 3/00, G06N 99/00

(54) **METHOD AND USER INTERFACE FOR MANAGING AND CONTROLLING POWER IN MODULAR ROBOTS AND APPARATUS THEREFOR**

(71) Applicant: Erle Robotics, S.L., 01006 Vitoria-Gasteiz (ES)
(72) Inventor: MAYORAL VILCHES, Víctor, 01006 Vitoria-Gasteiz (ES); MUÑIZ ROSAS, Aday, 01006 Vitoria-Gasteiz (ES); BILBAO CALVO, Asier, 01006 Vitoria-Gasteiz (ES); MUGURUZA GOENAGA, Iñigo, 01006 Vitoria-Gasteiz (ES); ZAMALLOA UGARTE, Irati, 01006 Vitoria-Gasteiz (ES)

(57) **Abstract**

A method for managing the power consumption of a modular robot is disclosed, being the overall power consumption of the robot the result of the individual power consumption of all its components following from certain power routines and inference techniques; a method that allows for an automatic inference and instant determination of the overall power consumption required by a modular robot is provided, such method also extended to the determination of the power consumption of a modular robot over a period of time; a method for training the behavior of a modular robot in a power-conscious manner according to a power inference source and a desired power consumption or a desired energy profile, using for that purpose Reinforcement and Imitation Learning techniques, is also disclosed; a method for monitoring and controlling the power consumption of the modular robot through a user interface conceived to that end is likewise disclosed; lastly, the robot apparatus therefor, a modular robot whose components own the electronics needed for the deployment of the disclosed method, is provided.

## Description

### Technical Field

The invention relates to the field of robotics generally, and more specifically to improved methods and apparatuses, as well as the user interfaces thereof, for managing the power consumption and the power profile of modular robots given their physical configuration and the capabilities of their components in accordance with the tasks which are carried out.

### Background Art

Manufacturers and developers are always striving to employ robots in both industrial and experimental contexts in the best power-efficient way. Current solutions go almost exclusively through modelling robots mathematically and using the resulting models to calculate the optimal consumption at each given moment, separately considered. Since the range of possible configurations with which a robot can be provided is infinite and this implies a huge number of models and sub-models with their respective parameters, the traditional approach does therefore not scale.

In addition, such approach would only be valid for frequently used robots whose configurations are known previously and appropriately modelled, what results in inaccurate estimations that do not comply with the dynamism that real-world scenarios require. What is more, the design and programming of modular robots would also require a big number of pre-compiled mathematical models that anticipate each one of the different possibilities which a modular robot may deal with, what ultimately turns out in too limited solutions.

On the basis of the above, each individual change on any of the robot components or parameters, or even on the desired task to be performed, will demand a complete re-execution of all following steps aiming to make the robot work: 1) modelling the robot's power consumption, 2) integration of components, 3) robot assembly, 4) programming the robot and 5) test and adapt.

As a result, any modification introduced in the robot will imply a big engineering effort in order for the output to remain unchanged under same power constraints. This limitation leads to highly time and resource-consuming approaches for building robots with deterministic power requirements, therefore to a scenario where optimizations and even accuracy are hardly achievable due to the complexity of the whole process.

Bypassing these drawbacks demands robot components that proactively send information about themselves for a dynamic integration of such information in the system and an automatic adaption to new tasks or physical and/or logical conditions like changing power requirements.

In accordance with modern market needs, rather than modelling the logic of robots in terms of power consumption in a restricted, expensive and limited way, as described above, it seems to be necessary to develop methods aiming at "learning to estimate power". This way, through real implementation and in an eminently automated way, the optimal power consumption state needed by a robot can be optimized regardless of the components present, their respective configuration or the surrounding environment.

Therefore, rather than analytically determining the overall power consumption through the information provided by components' manufacturers and then creating mathematical models for each component separately, this invention provides a way of conforming a suitable power model for the modular robot by determining the power consumption information of each component, individually considered, through the employment of a power inference method. Consequently, a way of managing and controlling the power consumption of modular robots is abstracted in neuromorphic models that mimic the behavior of mammals' brains and adapt themselves to changes and new experiences.

As for the prior art known at the moment of the application and regarded as useful for a better understanding of the invention, brief references to following documents are provided: CN106707019A, KR20170049306A, JP2008259331A, WO2018027572A1 and WO2018026124A1.

CN106707019A discloses an electric quantity monitoring device that collects electricity consumption information from a service robot, transmits it to a PC terminal in real time and, when finding electricity consumption abnormalities, is able to power off to protect the robot.

In KR20170049306A are presented an apparatus and a method for confirming the amount of charge required by the robot system, determining a power supply among a plurality of power sources in sequence and switching to them accordingly.

For its part, document JP2008259331A provides a charger device that ascertains the remaining battery level of a plurality of robots in order to determine which of them has to be charged while making the others switch to the power saving mode if certain battery threshold is reached.

Such methods and disclosures do not scale for robots since they do not provide the most sustainable power state beforehand, that is, the exact amount of power a robot requires, given certain task to be performed. Consequently, the above mentioned three inventions have to resort to less efficient techniques such as emergency switch-offs, methods for switching between alternative power sources until the needed power supply is matched or mere transitions to the power saving mode. Moreover, these approaches are not conceived for their implementation on modular robots.

In document WO2018027572A1, a method for detecting electric quantity information about a robot, acquiring an area where the robot needs to work and controlling whether the robot is charged or not according to the electric quantity information and the working area, is provided.

However, this method mainly focuses on the user experience and is limited to the ascertainment of the feasibility of certain task, given a trajectory to be performed and the current power status, therefore disregarding the need on improving learning techniques for achieving tasks following from power values not known by the robot beforehand. Moreover, such a method is not deployed on modular robots nor aims at performing a non-feasible task in a different way, for example changing the trajectory in order to fit the energy requirements when the given power status is not enough to realize the desired task.

Other robots and methods, as the disclosed in WO2018026124A1 for a typical vacuum cleaner robot, provide with automatized routines by which, when the remaining power of the battery falls below a certain power level, the robot is programmed to return to the charging device. However, such methods do not deploy Reinforcement Learning routines, what would enable them, through experience, to achieve tasks in an escalating power-efficient way, and therefore do not evolve to more advanced, Artificial Intelligence-based robots.

### Summary of invention

A method for managing and controlling power in modular robots is hereby disclosed. According to this method, given a set of robot components forming a modular robot (e.g. sensors, actuators, etc.) and an objective task to be performed, the best and optimal combination of such components is thereby inferred in order to enable the modular robot to execute the task by minimizing or adapting its power consumption, or by improving its behavior in conformity with certain desired energy profile.

Likewise, the method hereby proposed allows the logic of the modular robot to determine not only the right number of resources to be employed during the execution of the task, but also the right behavior the robot should follow for an optimal employment of such resources. This way, among the variety of possible different combinations of components existing in a modular robot and their relative power consumption, the best and optimal trajectory aiming at accomplishing certain task is automatically inferred from trained neuromorphic models that rely on Artificial Neural Networks. Such models are typically developed through the employment of techniques such as Reinforcement Learning or Imitation Learning.

As a result of the deployment of the disclosed method, a modular robot whose modules send independent information about their power requirements and that is able to use such information in order to optimize the consumption of the components as well as the overall consumption, or otherwise adapt itself to the nature of the task to be performed or to a desired energy profile, is also provided.

### Brief description of drawings

Fig. 1 is flowchart describing the method for managing and controlling the power consumption of the modular robot.
Fig. 2 is screenshot of the user interface where the consumption of one component, in terms of current, power and voltage, is displayed.
Fig. 3 is a screenshot of the user interface where the calculated trajectories and the relative power consumption of the chosen one, as well as the successful or failure of which, are displayed.
Fig. 4 is a screenshot of the user interface where the estimated overall consumption of the robot while performing the desired task, the selected components therefor and the energy profile chosen to this effect, are displayed.
Fig. 5 is a modular robot whose components autonomously send information about their relative power consumption requirements.

### Description of embodiments

In a first aspect of the invention, given a set of robot components forming a modular robot 50, each one of them communicating and exchanging information in a distributed way, the method hereby disclosed allows for an automatic and instant determination of the overall power consumption required by the robot for the execution of certain task 57. The overall consumption can be described as the sum of the individual power consumption of all components coexisting in a modular robot at a given time 51-56, including copper losses while distributing the power through the system.

The method proposed begins with the carrying out of a series of individual, component-wise power measurements 10 together with some power initialization routines 11 consisting on a set of movements and exercises to be executed by the modular robot. These first two steps are aimed at determining the overall power consumption 41, typically represented as the sum of the individual consumption of all modules, in different power states, including the consumption following from switching on/off components and the acceleration or deceleration consumption of actuating parts.

According to this method, a suitable power model for the modular robot can be conformed by determining the power consumption information of each component, individually considered 20, through the employment of a power inference mechanism 12. As additional function, the method also provides a concrete way for the modular robot to perform the given task by complying with certain energy profile 13. The alternatives are 1) a velocity-oriented energy profile, 2) a strength-oriented energy profile or 3) a consumption-oriented energy profile 43. Both the data following from the power inference 12 and from the selected energy profile 13 may be employed to shape the rewards around which the training process 14 will orbit, thereby making the modular robot aware of a particular set of constraints previously established and derived from its current assembly.

Working on a distributed way, all components within a modular robot, each of them with their own processing capabilities, will steadily be exchanging information through a common networking environment. In some embodiments, communication middlewares based on the publish/subscribe methodology can be employed. Examples of such communication middlewares include the Data Distribution Service (DDS), the more abstract Robot Operating System (ROS) middleware or the OPC UA binary protocol. Other communication middlewares such as DDS for eXtremely Resource Constrained Environments (XRCEs) may also be used to interface components with limited resources that would later be bridged into any of the other publish/subscribe middlewares mentioned.

Among the range of data susceptible to be exchanged, every module will report its consumption profile, at least, in terms of current 22, power 23 and voltage 24. The published data are dynamically treated thus they may either be or not be of use for the purpose sought at a given time. If not useful, they will be simply disregarded by the processing unit 51 but continue on being available for if the desired behavior 31 or the physical characteristics 42 of the modular robot eventually change. In any case, the power consumption data of the individual components, either useful or not, will be at the operator's disposal through the user interface in form of downloadable logs 21, so that they can be monitored and irregularities or fails rapidly identified and fixed.

As a basic premise, it has to be taken into account that a too wide range of scenarios may be present, whereas the repertory of possible existing parts within a modular robot at a certain time is likewise extensive. Similarly, not all components could perform the complete pattern of movements nor play the same role, given their particular topologies. Some exemplary cases of such a set of movements and roles are camera components taking or not taking pictures, or actuators being idle, in movement or in a high torque static position, among many others. Therefore, pre-emptively and in order to compile a sufficiently comprehensive batch of feasible trajectories for performing a given task, alongside with the power consumption linked to each one, as much movements and combinations as needed have to be performed. Provided that each component owns the electronics to determine the amount of power being consumed 10 while performing the above mentioned set of actions 11, they are thus able to compile, translate and transmit such information through the robot communication network by themselves. Consequently, all power consumption data is at the processing unit's 51 disposal for when the robot is set to build its power model during the power inference phase 12 of the method proposed.

In a second aspect of the invention, accurate predictions of the power to be consumed during defined periods of time (e.g. minutes, hours), subject to different combinations of movements, can be provided by using certain power inference techniques or mechanisms 12. Through such techniques, the power consumption of the modular robot is estimated while taking into account the range of possible activities the robot might be performing (e.g. two completely different power states such as remaining static in the same position or otherwise being moving around), according to the power measurements 10 and initialization routines 11 carried out beforehand. The results of these predictions are compiled under power models which will later be used in training mechanisms through varied neuromorphic techniques 14.

In some embodiments, in order to infer the overall power consumption of the robot at a given time 12, it is possible to build the above mentioned power models through Supervised Learning techniques typically consisting on capturing such power models with neuromorphic representations, most commonly Artificial Neural Networks trained with backpropagation. Other algorithms and techniques for Supervised Learning could also apply and some examples include but are not restricted to Support Vector Machines, linear regression, logistic regression, nearest neighbor methods, naive Bayes, decision trees, linear discriminant analysis, genetic programming, evolutionary algorithms, random forests or ensembles of classifiers, among other. Any of the mentioned techniques could be used to build the power model which will be then employed to execute the power inference 12 in a simulated environment where the modular robot undergoes a training process. This training process 14 will typically be implemented through the use of Reinforcement Learning or Imitation Learning techniques and aims at accelerating the process of determining the right power configuration of the modular robot to accomplish a given task.

In a third aspect, a method for determining the right combination of components of a modular robot and the corresponding actions needed to accomplish a given task while meeting some power-related objectives is provided 14. Such method is performed through the employment of training routines that follow from Artificial Neural Networks and Reinforcement or Imitation Learning techniques and allow for a simulation-assisted development comprising a high amount of iterations and a considerable reduction of efforts in terms of time and consumption of resources. This way, by using the input from a power inference mechanism 12 and/or from an energy profile 13, this method develops a training process consisting of automatic simulations that output predictions on the feasibility of the robot's performance when considering different combinations of modules 14.

With the introduction of a "power consumption factor" 12 in the learning process, the invention hereby disclosed aims to make machines learn 14 in a power-conscious manner. Moreover, by actively promoting certain power requirements 13 for the consecution of rewards, a method aiming at teaching the robot to identify and make the most of the advantages of performing the given task in a more power-conscious manner will be thus triggered. In a few words, if the typical reward-based process rests on the power information (so that, for example, the less power consumption implies the more positive reward and vice versa), the cognition of the robot will thereby be able to ascertain the optimal combination of modules and their power modes, what, while executing the learning task, helps the robot to reduce and optimize the amount of power consumed 41. In addition, the employment of cloud services as platform for a learning process based on a high amount of iterations promotes that the set of results is obtained faster and exponentially augmented, therefore the range of assessable values larger and the inference results more reliable.

Next to the power inference method 12, further key factor in the development of this invention is the establishment of preferred energy profiles 13 that will likewise draw up and have crucial influence on the training process that follows. This way, once the consumption parameters have been measured 10-12 and registered 21, a velocity-oriented energy profile, a strength-oriented energy profile or rather a consumption-oriented energy profile 43 may be chosen during the training process in order to shape it, according to the kind of efficiency sought for the robot. A velocity-oriented energy profile will determine a faster or slower way of carrying out the desired task, so that the velocity of execution would stand out from other requirements. A strength-oriented energy profile highlights the intensity or vigour of the machine while executing the task, prioritizing rapid and hectic movements over smooth ones or vice versa. A consumption-oriented energy profile seeks a deployment based on a minimal power consumption eminently, though disregarding factors such as the velocity of execution. However, a high-performance energy profile that maximizes the consumption may likewise be selected if a maximal exploitation of all robot capabilities is sought. The energy profile will thus be determined by the desired performance in accordance with the desired task 13, being also possible to conceive a combination of resources that balances the behavior of the robot in a both velocity and consumption-oriented way, in a consumption and strength-oriented way, in a strength and velocity-oriented way or in a well-balanced combination of the three. The provided user interface allows for such a deployment 43.

The training process 14 hereby described happens mainly in simulation, what facilitates a larger range of iterations and a more comprehensive list of reasonable scenarios to work with. The steps comprehended between the power measurement and the selection of trajectory and components 10-15 involve a chain of items where different forms of artificial intelligent techniques could be applied. In some embodiments, a Supervised Learning training process provides a power inference mechanism 12 later used during a Reinforcement Learning 14 training process in order to determine the most efficient combination of components and actions thereof for performing a given task. In other embodiments, a Supervised Learning 12 training process provides a power inference mechanism later used during an Imitation Learning 14 training process in order to likewise determine the most efficient combination of components and actions thereof for performing a given and demonstrated task. In other words, the methods presented hereby advocate for power-sustainable modular robots.

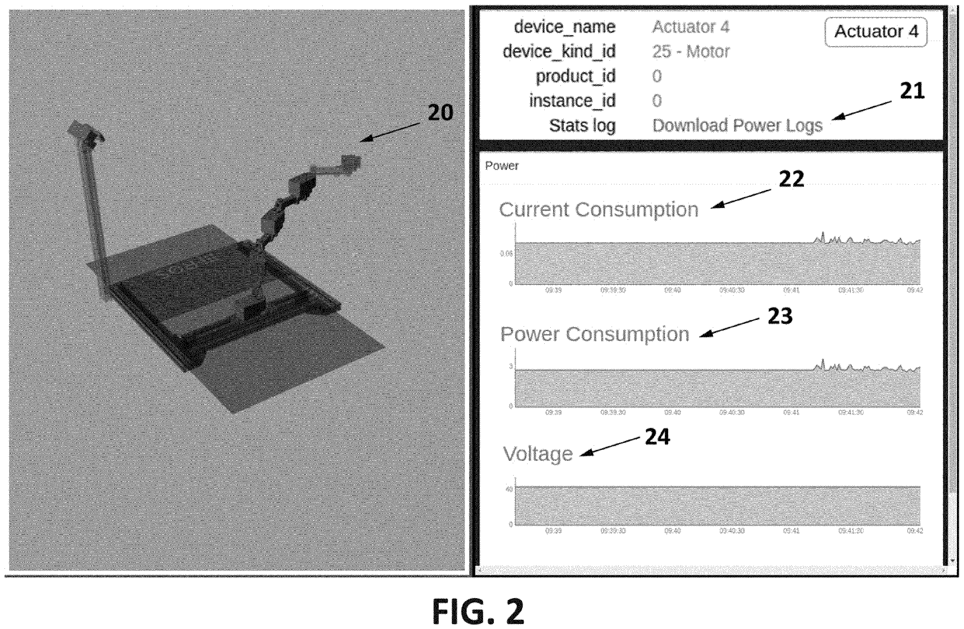

In a fourth aspect of the invention, the method proposed also allows to manage and control the amount of power consumed individually by each one of the modules existing in the modular robot, selectively switching them on or off and instructing them appropriately 15, so that the efficiency of the overall robot is maximized when performing the desired task in accordance with the desired energy profile, if selected. In order for that to happen, the method provides a user interface, as represented in Figs. 2 to 4, with main functionalities comprising yet not limited to:
- Modular robot and workspace 3D display 40, including but not limited to a 3D representation of the assembled modular robot in accordance with a preferred embodiment 50 and the workspace comprising a red point that depicts the place where the end-effector is placed over and a blue square that represents the place where the target of the end-effector is set in.
- Behavior deskwork 43, where the user can set the desired parameters to be taken into account while training the neuronal network, such as certain maximal or minimal power consumption, maximal or minimal number of movements, specific components 42 to be deployed during the simulations or available trajectories 31.
- Power consumption display 41, comprising a power reading history of the different robot behaviors deployed in simulation 32, including individual readings of the components' power parameters, sorted by time or amount 21, being therefore possible to detect consumption peaks and valleys or irregularities.

Once the neural network has been successfully taught as a result of the training step 14, the range of possible behaviors to be deployed on the robot can be managed through the above described user interface 31. This user interface is designed to check the overall power consumption parameters 41 already measured 10 in accordance with the results of the power initialization routines 11 and consumption inferences 12, as well as the selection of the energy profile 13, and allows to control both the number of components to be employed and the way to do that 15, 42, 43, as explained below:
- Given P1, P2, Pn... power consumption for C1, C2, Cn... tested components 20, either the desired Pt consumption or the desired Ct number of components for performing certain task is chosen among the range of movement possibilities or M1-n trajectories 31, ascertained beforehand during the training process 14.
- Archetype of the power control and management usability disclosed by this method is the establishing of limits such as the maximal amount of power capacity to be employed, so that the desired task may be defined by relying on a limited amount of power or a limited group of components, being the neural network trained for executing the task in accordance with a pre-established framework 42, 43. In this sense, three different energy profiles may be chosen, as explained above: 1) velocity-oriented energy profile, 2) strength-oriented energy profile or 3) consumption-oriented energy profile.
- As a result, the relative power consumption of each component 22, 23 given certain trajectory 31 (P1M1-n, P2M1-n, PnM1-n...) is determined and the neural network rewarded or penalized in conformity with the training process described above and detailed below as a preferred embodiment of the invention.
- Whether the task is feasible or not, given certain maximal or minimal desired Pt (total amount of power) and certain maximal or minimal desired Ct (total number of components) to be employed, or a combination of both, the user interface outputs a signal (in form of light, sound or command signal) 33 that indicates the success or failure of the whole process. A success should be interpreted as that the method has accomplished adapting robot for performing certain task given Pt or Ct limitations. A failure signal should be understood as that the robot is not able to execute the defined task given Pt or Ct constraints, or a combination of both.
- Failures will typically be related to the fact that the available power source or the means for transporting the electric energy are not adequate for the desired behavior, although a positive output can be obtained through simulation 30. Otherwise may the component be the one not enduring the given power supply, either because of its intrinsic technical and electrical capabilities or because of its wear. These difficulties and drawbacks can be easily addressed through the user interface 21, 33 and solved by replacing either the power means or the component itself, or by setting up new simulation parameters, for example through the configuration of a set of movements requiring less consumption 31, or otherwise penalizing the neural network if certain undesired behavior is performed.
- The power consumption of related components (e.g. the processing unit 51) may not be taken into account during the measurement process, given that such parameters can be considered as regular or common ones during the whole process, thereby they are not crucial for the ascertainment of the optimal power consumption. Likewise, the power consumption of non-active components is most times close to zero, therefore not crucial in terms of measurement. Nevertheless, it is important to distinguish switch-offs of power sources where the energy is zero, from partial or virtual switch-offs where the processor of the component is turned on, but its mobility not allowed. In this latter case, certain power consumption, although close to zero, will always exist and may be verified by downloading a power consumption log 21.
- Among the resulting range of possibilities for successfully performing the task 31, the more desirable and optimal of those combinations to be deployed on the robot 33, 44 may be chosen through the user interface. This allows users to maximize the efficiency of the robot in the desired way, that is, in a velocity, strength or consumption-oriented way, either are certain Ct components used or certain maximal or minimal Pt consumed.

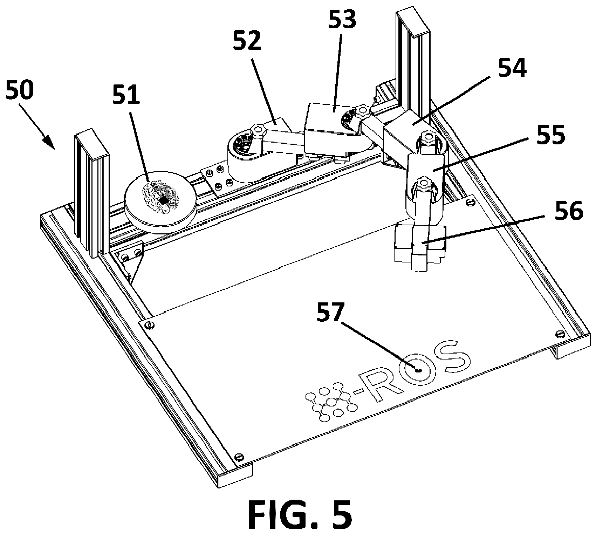

In a fifth and last aspect of the invention, an apparatus (a modular robot) 50, whose components 51-56 are able to autonomously send information about their relative power consumption requirements, is provided. The apparatus hereby disclosed is a highly reconfigurable and adaptable modular robot, thereby its modular parts may be easily added, replaced or removed without varying the usability of the robot. The great autonomy of the modular parts and the use of communication standards between them facilitates the ease of repurpose, making it possible to steadily improve or at least keep the performance of the modular robot unaltered, no matter which components are present, given that the desired behavior is physically feasible. Nevertheless, for the sake of simplicity and especially aiming at developing the method hereby proposed, this invention discloses a typical robot with a SCARA 50 configuration that performs single-axis movements, with following modular parts: a brain or processing unit, four actuators and an end-effector, as represented in Fig. 5.

Such robot modular parts feature a central processing unit (CPU) and additional programmable logic typically realized in the form of an FPGA, as well as volatile and non-volatile memory, a network interface, sensors, actuators, etc., and, in the context of this invention, comprise a code that makes it possible to register their actual state in terms of current, voltage and power through a user interface 22-24. As a result of the information shared using a specific robot middleware and the employment of the method hereby described 10-16, this modular robot optimizes its power consumption while executing certain task 17.

Following from the method disclosed and as a preferred embodiment as explained below, the modular parts present in the modular robot are set to perform the range of available movements during the power initialization routines 11. Although these movements are conditioned by the actual physical model of the robot, the power consumption is likewise measurable and suitable for the purpose aimed by the method hereby disclosed, whether it is about simple single-axis movements in less complex robots (like the one presented in Fig. 5 with a SCARA configuration 50), or otherwise a wide range of movements in different axes traced by more complex robots.

The modules forming modular robots as the described by this invention 51-56 are equipped with electronics that enable them to measure and register their relative power consumption values 10. For example, either voltage and current measurement units that can be designed using different techniques such as current measurement through shunt resistor, or more complex designs comprising magnetic or hall effect sensors depending on the power rating of the robot module, may be interchangeably employed. These values are transmitted to the main microcontroller or microprocessor of each robot component, where interpreted and the appropriate transformations made in order to translate them to quantifiable values and send them through the shared network. These data are retrieved and compiled by the processing unit 51 in order to provide the power inference mechanism 12, monitored by Supervised Learning techniques as described above, with the information needed, that is, the power consumption factor for training neural networks.

The training process 14 hereby described happens mainly in simulation. Nevertheless, since a direct handling of the modular robot by operating the user interface, either discretionary or through pre-set behaviors 31, is likewise possible, simulations may also be deployed on a real world-based scenario 16 once a concrete trajectory and the components committed to it are selected 15. In any case, since the resulting behavior model or trained logic of the robot can be processed as a computer file able to be exported, the result of the training process 14 can be transferred to the robot itself 17 or elsewhere needed at any time.

### Additional description of the drawings

In order to complement the description being made and aid towards a better understanding of the characteristics of the invention, in accordance with a preferred example of practical embodiment thereof, a set of drawings is attached as an integral part of said description, wherein, with illustrative and non-limiting character, the following has been described:

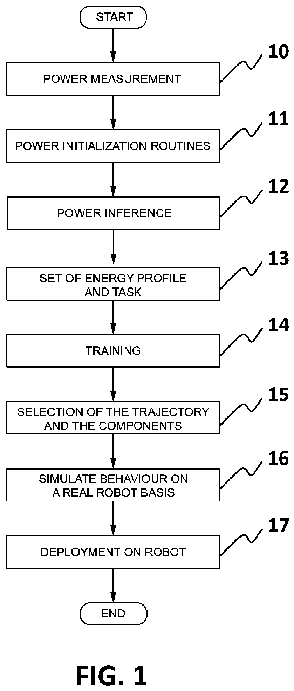

- Fig. 1 is a flowchart of the steps comprising the method disclosed. As preliminary steps, basic power measurements 10 alongside with a set of power initialization routines 11 are deployed on the robot in order to reproduce the estimated power consumption of the modular parts of the robot, given certain set of movements. After that, the power consumption of all modular parts is registered, compiled and transmitted through the inner communication network of the modular robot. The third step features the realization of the power inference mechanism 12 aiming at predicting, based on the data compiled in the previous steps and by using Supervised Learning techniques, the feasibility of the desired task in accordance with the energy to likely be consumed, thereby conforming a suitable power model. As a fourth step, although this part is usually known beforehand, the task to be performed and the energy profile the robot will be based on during such performance, are defined 13. The fifth step comprises the training process 14 of the logic of the robot by using Reinforcement Learning or Imitation Learning techniques on Artificial Neural Networks yet including a power consumption factor following from the inference mechanism in order to shape the reward-based methodology of training. Once a set of successful behaviors is defined, the sixth step comprises the selection of the desired trajectory and the components committed thereto 15. Previous to the last step, simulated behaviors 16 based on the real robot may be performed by interacting with the user interface, so that last-minute failures can be addressed and fixed prior to the deployment of the desired behavior on the robot itself. As a last step, the result of the overall process is executed on the real robot 17.
- Fig. 2 is a screenshot of the user interface employed for monitoring and controlling the power consumption of the modular robot. In this embodiment, the power consumption of just one of the components is showed 20. The system registers the relevant data of the selected component in terms of current 22, power consumption 23 and voltage 24 and variations are represented as peaks and valleys in the graphical overview. This way, the user can monitor the exact power consumption of a component while realizing a concrete set of movements, being also allowed to compare it with other simulation data corresponding to another set of movements. This monitoring likewise enables the user to check for power abnormalities or compile logs 21 of the overall state of the robot at a given time.

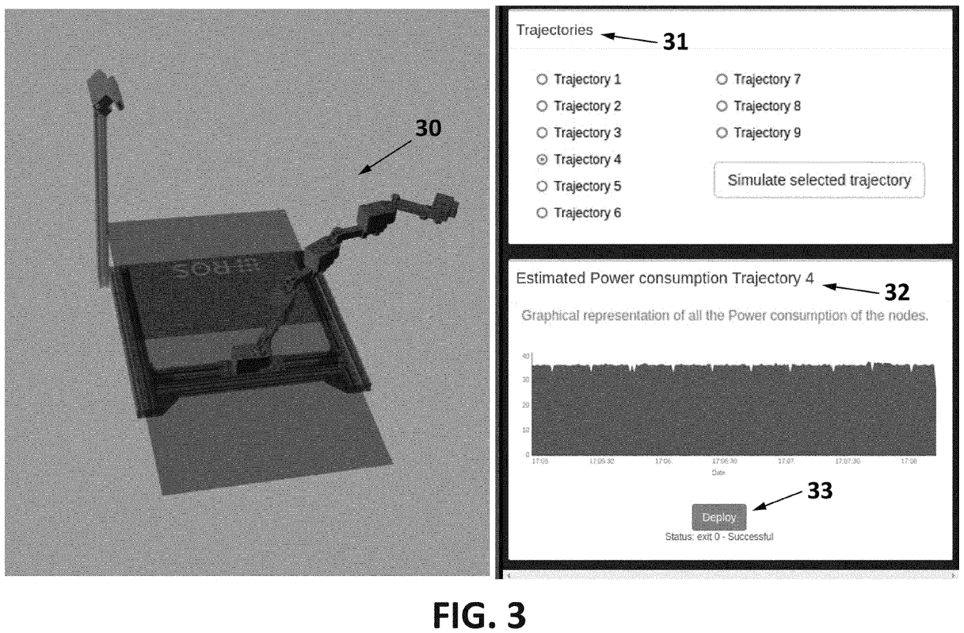

- Fig. 3 is a screenshot of the user interface where a simulation deskwork for the modular robot is provided 30. In this embodiment, a concrete trajectory is chosen 31 among the trajectories that have been trained beforehand and deployed 33 for visualization. Therefore, the specific behavior is shown on screen 30 and its estimated power consumption represented in charts 32. A message pointing out the successful of the simulation is likewise displayed 33.

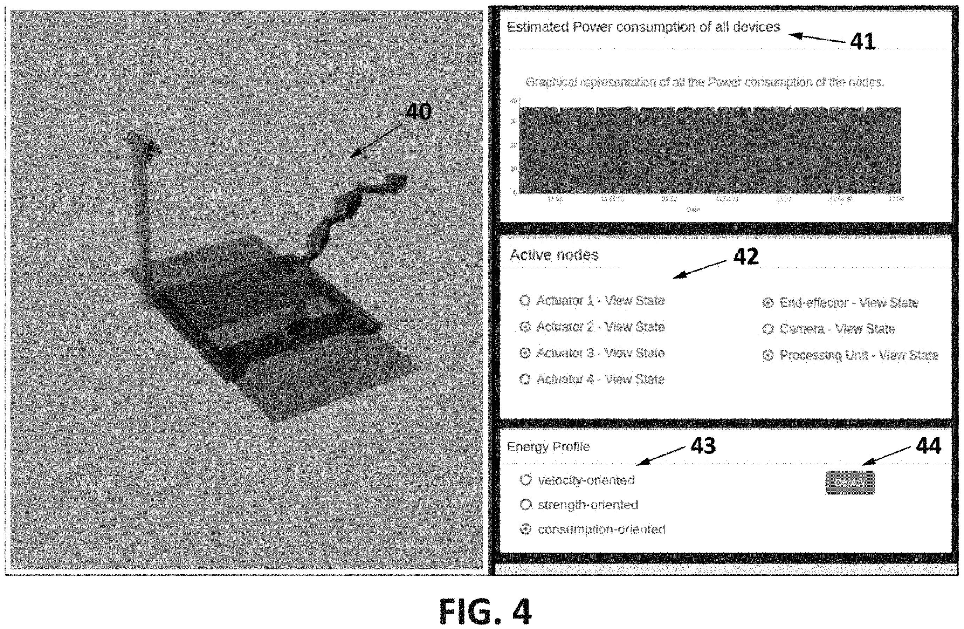

- Fig. 4 is a screenshot of the user interface that represents the estimated power consumption of all devices 41 once the desired trajectory has been determined 40, according to all steps, including the selection of a desired power consumption or a desired power profile, described in the method proposed. The user interface also allows for a monitoring of the modular parts being employed 42 and the energy profile chosen 43. The "deploy" tab 44 is used for executing the programmed behavior on the real robot.
- Fig. 5 is a representation of a modular robot 50 whose modules are able to autonomously send information about their relative power consumption requirements for performing certain task 57 and that comprises a processing unit 51, four actuators 52-55 and an end-effector 56.

### Preferred embodiment of the invention

In a preferred embodiment, the method hereby disclosed is deployed in a processing unit localized in one of the components 51 of the modular robot. The processing unit will likewise be in charge of coordinating the logic that powers the robot. Alternatively, a higher number of components working in a distributed way within the modular robot can operate as simultaneous processing units, being thereby able to coordinate the robot operation in a distributed way. The modular robot 50 in which the disclosed method is deployed typically comprises six components, being these: 1) a processing unit 51, 2) a first actuator 52, 3) a second actuator 53, 4) a third actuator 54, 5) a fourth actuator 55 and 6) an end-effector 56.

In a preferred embodiment, the power measurement 10, performed in accordance with the power initialization routines 11 carried out by the different actuating components present in the robot 52-56, comprises the execution of the set of movements that each component is able to. This way, actuators and end-effector start to trace the shortest trajectory needed to provide the whole structure with the minimal mobility required in order to approach the desired point 57, which is the task to be performed, in the workspace.

Partial power consumption values may gradually be registered, compiled and transferred to the processing unit, what allows for the carrying out of partial power inference mechanisms 12 while power initialization routines continue on being performed simultaneously. If not satisfying, the provisional sets of routines are discarded, further longer trajectories are consecutively executed and power consumption data compiled and processed. On user's demand, the power initialization routines may be set to finish once a comprehensive range of power consumption values has been registered and simulations can thereby be accurate enough for the purpose sought, whether a desired maximal power consumption or an energy profile 13. If the collected data sample is not satisfactory, further routines may be performed and supported with human assistance.

Given the result of partial and overall power measurements 10 and initialization routines 11 and their translation into respective power parameters in accordance with power inference mechanisms 12, the range of existing combinations of movements forming trajectories that are valid for performing the desired task 57 is automatically determined by the processing unit or units, which makes use of these data while training the neural network 14.

In a preferred embodiment, the chosen energy profile is the consumption-oriented one 43, so that the objective will be to accomplish the desired task 13, represented by the end-effector being placed over the desired point in the workspace 57, consuming as little power as possible 41. That is, the described preferred embodiment represents the behavior of a sustainable modular robot.

In accordance with a preferred embodiment of the disclosed method, a basic schema of the steps comprising the monitoring of the power consumption and the training of the logic of the robot 14 is explained below, where M1, M2, M3, M4, Mn... (M1-n) movements are possible satisfying trajectories to be executed by the robot; C1, C2, C3, C4 and C5 are employable actuating components given different combinations, represented by Ct as the sum of the components employed according to a preferred embodiment (Ct = 1 to 5); P1, P2, P3, P4 and P5 are the power consumption of C1, C2, C3, C4 and C5, respectively; P1M1-n, P2M1-n, P3M1-n, P4M1-n and P5M1-n are the relative power consumption of each employable component given a number of possible trajectories (M1-n); PtM1-n is the overall power consumption of M1-n, given the components employed (Ct); and R1-n are the amounts of reward conferred to certain behaviors or M1-n, being R in the (-∞,∞) set:
- As a preliminary step, a baseline power measurement is set. This baseline symbolizes a representative and desired amount of power to be consumed by taking, as reference, approximative inferred power consumption values in accordance with the result of the pre-set routines and mechanisms. Such standard, represented as PtM0, shapes the relative value of the rewards to be conferred, so that the closer to PtM0 the subsequent PtM1-n are, the higher R1-n reward will the respective M1-n get. A neutral reward (R = 0) will be conferred to the more distant value of PtM1-n with respect to PtM0 that is considered acceptable, provided that it is contained in the range of maximal amount of power taken into consideration for the purpose sought. In a preferred embodiment, amounts out of the range of acceptable values and therefore worthy receiving negative rewards (R = -n) are automatically discarded.
- If M1 employs Ct = 4 (C1, C2, C3 and C4) components, being the overall power consumption of M1 (PtM1) the sum of P1M1, P2M1, P3M1 and P4M1, certain amount of reward (R) is conferred to the neural network. In a preferred and exemplary embodiment, the conferred reward for the M1 behavior is R1 = 0, considering that the power consumption is at the limit of the range of acceptable values.
- If M2 employs Ct = 3 (C1, C2 and C3) components and its overall power consumption (PtM2, which is the resulting sum of P1M2, P2M2 and P3M2) is lower than the overall power consumption of M1 (PtM2), the reward conferred to M2 will be R2 = 1.
- If M3 employs Ct = 2 (C1 and C2) components and its overall power consumption (PtM3, which is P1M3 plus P2M3, being P3M3 equal to zero or almost zero) is lower than PtM1 but higher than PtM2, such movement is rewarded with R3 = 0,5.
- If M4 employs Ct = 2 (C1 and C3) components and its overall power consumption (PtM4, which is the sum of P1M4 and P3M4, being P2M4 equal to zero or almost zero) is even lower than PtM2, the conferred reward is R4 = 1,5.
- In a preferred embodiment, the simulation is performed as many times as desired by using cloud services as training platforms. This allows to exponentially augment the number of iterations and therefore the amount of testing results, what facilitates the evaluation of which and the determination of the most desired behaviors in smaller time frames. Also, it can alternatively be deployed in the robot itself, in a server or servers connected to the robot under the same network, or in a number of servers that are available at the Internet (cloud services), as already mentioned. Nevertheless, since the resulting model can be processed as a computer file able for exportation, the result of the training process can be transferred to the robot or elsewhere needed afterwards.
- For the sake of simplicity, in view of the aim followed by this invention, the power consumption of related components such as the processing unit 51 has not been taken into account during the measurement process, provided that such parameters can be considered as regular or common during the whole process, thereby not being crucial for the ascertainment of the optimal power consumption. Likewise, the power consumption of non-active components is most times close to zero, therefore not crucial in terms of measurement.
- Once M1-n movements have been trained, the at the utmost rewarded Mx trajectory will be identified as the optimal and more efficient way to perform the desired task. In a preferred embodiment of the invention, M3 employing C1 and C3 with their respective P1M4 and P3M4 power consumptions, will be the optimal trajectory and a positive signal will thus be displayed in the user interface 33.

In a preferred embodiment, the result of the training process is displayed in the user interface 31, so that all deployed behaviors with their respective power consumption parameters are listed 21, being thus possible to compare between them and choose either the most optimal trajectory or any other possible trajectories, given the desired power consumption 32. The individual power consumption of each component according to certain set of movements is likewise displayed 22-24, so that abnormalities or undesired parameters may be easily localised and isolated, and the specific problem fixed. Likewise, by managing the user interface, modules may alternatively be switched on and off 42, so that the power consumption is subject to be monitored and limited insofar as the consumption of non-usable components is set to zero or to an almost irrelevant value.

## Claims

1. A method for managing and controlling the power consumption of a modular robot, wherein: the power consumption of the individual modular parts is measured while the individual modular parts execute a set of power initialization routines aiming at estimating the overall power consumption of the modular robot; the optimal power consumption of the modular robot is inferred by taking into account the range of possible activities the modular robot might perform in accordance with a given assembly, thereby generating a power model, typically although not necessarily, with a neuromorphic representation; a preferred task among the range of tasks physically feasible is set; optionally, a desired energy profile for the execution of the preferred task is set; the behavior of the modular robot is trained following from an inferred power model, so that the modular robot learns to execute a given task in a power-conscious manner, preferably in simulation; a preferred behavior among the range of successful trajectories trained with their respective modular parts, is selected; the trained behaviors can be simulated on a real robot basis; a selected behavior can be deployed on the real robot.

2. The method of claim 1, wherein the optimal power consumption of the modular robot while executing certain task is estimated following from power inference mechanisms based on Supervised Learning techniques such as Artificial Neural Networks, Support Vector Machines, linear regression, logistic regression, nearest neighbor methods, naive Bayes, decision trees, linear discriminant analysis, genetic programming, evolutionary algorithms, random forests or ensembles of classifiers.

3. A method for training the behavior of a modular robot in accordance with claim 1, wherein the logic of the modular robot assesses all satisfying trajectories for successfully performing a desired task and automatically infers the more power efficient way to do so.

4. The method of claim 3, wherein the logic of the robot automatically learns the more efficient way to perform certain task according with a desired power consumption or a desired power profile.

5. The method of claim 3, wherein the user decides on the concrete trajectory, among all satisfying trajectories, to be performed by the modular robot while executing the desired task.

6. The method of claim 3, wherein: the system can be set to a velocity-oriented power profile; the system can be set to a strength-oriented power profile; the system can be set to a consumption-oriented power profile.

7. The method of claim 3 using Reinforcement or Imitation Learning techniques to train Artificial Neural Networks, wherein: rewards are shaped using the power consumption factor derived from a previous Supervised Learning process; the less power consumption implies the more positive reward; the more power consumption implies the less positive reward; the more efficient behavior is the most rewarded one thus the more power-conscious one.

8. The method of claim 3 in accordance with claim 7, wherein the training process can be deployed in the robot itself, in a server or servers connected to the robot under the same network, or in a number of servers that are available at the Internet, or cloud services.

9. The method of claim 3 in accordance with claims 7 and 8, wherein the resulting trained model can be processed as a computer file able for exportation, thereby the result of the training process can be transferred to the robot itself or to other robots.

10. A method for monitoring and controlling the power consumption of the modular robot in accordance with claims 1 to 9 by employing a user interface conceived to that end, wherein the user interface provides: a modular robot and workspace 3D display; a behavior deskwork; a power consumption display.

11. A robot apparatus whose modular parts are able to autonomously measure and send information about their relative power consumption requirements while executing power initialization routines in accordance with claim 1.

12. The robot apparatus of claim 11, wherein at least one processing unit compiles the power consumption data sent by the modular parts and execute power inference techniques in order to create a power model in accordance to claims 1 and 2.

13. The robot apparatus of claim 11, wherein at least one processing unit trains the logic of the robot for learning to behave in a power-conscious way in accordance to claims 3 to 9.

14. The robot apparatus of claims 11 to 13, wherein various modular components working in a distributed way can act as simultaneous cooperative processing units, being thereby able to coordinate the robot operation and training in a distributed way.

15. The robot apparatus of claims 11 to 13, wherein the learned behavior is deployed for performing a desired task.
